# EUROPEAN PATENT SPECIFICATION

(11) **EP 4 068 929 B1**
(45) Date of publication and mention of the grant of the patent: **13.03.2024**
(21) Application number: 21306186.4
(22) Date of filing: 31.08.2021
(51) Int. Cl.: H05K 7/20

(54) **A RACK SYSTEM FOR HOUSING AN ELECTRONIC DEVICE**
RACKSYSTEM ZUR AUFNAHME EINER ELEKTRONISCHEN VORRICHTUNG
SYSTÈME DE BÂTI POUR ACCUEILLIR UN DISPOSITIF ÉLECTRONIQUE

(30) Priority: 01.04.2021 EP 21305427
(43) Date of publication of application: 05.10.2022
(73) Proprietor: OVH, 59100 Roubaix (FR)
(72) Inventor: CHEHADE, Ali, 59283 Moncheaux (FR); BAUCHART, Grégory Francis Louis, 59150 Wattrelos (FR); MENEBOO, Alexandre Alain Jean-Pierre, 62440 Harnes (FR); KLABA, Henryk, 59100 Roubaix (FR)
(74) Representative: BCF Global

(56) References cited:
- US-A1- 2011 267 768
- US-A1- 2011 286 177
- US-A1- 2012 075 797
- US-A1- 2018 084 671
- US-A1- 2020 196 489
- US-A1- 2020 214 169

## Description

### CROSS-REFERENCE TO RELATED APPLICATIONS

The present patent application claims priority from European Patent Application Number 21305427.3, filed on April 1 2021.

### TECHNICAL FIELD

The present disclosure generally relates to a rack system and, in particular, to a rack system for housing an electronic device.

### BACKGROUND

Electronic devices, for example servers, memory banks, computer discs, and the like, are conventionally grouped in rack structures. Large data centers and other large computing infrastructures may contain thousands of rack structures supporting thousands or even tens of thousands of electronic devices.

The electronic devices mounted in the rack structures consume a large amount of electric power and generate a significant amount of heat. Cooling needs are important in such rack structure. Some electronic devices, such as processors, generate so much heat that they could fail within seconds in case of a lack of cooling.

Forced air-cooling has been traditionally used to disperse heat generated by the electronic devices mounted in the rack structures. Air-cooling requires the use of powerful fans, the provision of space between the electronic devices for placing heat sinks and for allowing sufficient airflow, and is generally not very efficient.

With further advancements, liquid-cooling technologies, for example using water-cooling, and immersion cooling technologies, for example using dielectric immersion cooling liquids are increasingly used as an efficient and cost-effective solution to preserve safe operating temperatures of the electronic devices mounted in the rack structures.

However, it is to be noted that when using the immersion cooling technologies, a dielectric immersion cooling liquid fills an immersion case that provides housing to the electronic devices in the rack structure. This leads to deformation of the immersion cases and as a result, it may cause inconvenience while performing racking or de-racking operations of the immersions cases from the rack structure. Using heavy or thick materials to add rigidity to the construction of the immersion cases would be costly and require the use of even sturdier rack structures.

With this said, there is an interest in designing effective immersion cases for the rack structure that reduce the above-mentioned inconvenience.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

US 2012/075797 A1 discloses a liquid submersion cooling system that is suitable for cooling a number of electronic devices in parallel using a plurality of cases connected to a rack system. The system cools heat-generating components in server computers and other devices that use electronic, heat-generating components and are connected in parallel systems. The system includes a housing having an interior space, a dielectric cooling liquid in the interior space, a heat-generating electronic component disposed within the space and submerged in the dielectric cooling liquid. The rack system contains a manifold system to engage and allow liquid transfer for multiple cases and IO connectors to engage electrically with multiple cases/electronic devices. The rack system can be connected to a pump system for pumping the liquid into and out of the rack, to and from external heat exchangers, heat pumps, or other thermal dissipation/recovery devices.

US 2011/286177 A1 discloses a liquid submersion-cooled computer that is configured to reduce physical structures passing through walls of the computer liquid-tight computer case, which eliminates the amount of sealing needed around those physical structures and reduces the number of possible fluid leakage paths from the interior of the computer that contains a cooling liquid submerging at least some of the computer components. The computer includes a mechanism to pass input/output signals into and from the computer without any physical structure extending through any of the plurality of walls. The computer also has a mechanism for wirelessly transferring power into the interior space of the computer case, and a switch that controls power in the computer without having any physical structure extending through any of the plurality of walls.

US 2011/267768 A1 discloses a liquid submersion cooled computer that includes a seamless, extruded main body used to form a liquid-tight case holding a cooling liquid that submerges components of the computer. By forming the main body as a seamless extrusion, the number of possible leakage paths from the resulting liquid-tight case is reduced. No seams are provided on the main body, and there are no openings through the walls of the main body, so liquid cannot leakage through the main body. Any leakage paths are limited to joints between the main body and end walls which are sealingly attached to the main body to form the liquid-tight case.

US 2018/084671 A1 discloses a liquid immersion tank capable of withstanding, though made of a resin, a load of coolants and keeping dimensional accuracy. The liquid immersion tank including: a tank body being receivable of an electronic equipment and filled with a fluorine-series insulating coolant; and a fixing portion being provided on an inner wall surface of the tank body and receiving fixation of the electronic equipment, the tank body being equal to or smaller than 2% in modulus of volume change when immersed in the fluorine-series insulating coolant, and being composed of a resin material being equal to or smaller than 15×10-5/K in coefficient of linear expansion.

US 2020/196489 A1 discloses a heat dissipation apparatus for a plurality of heat-generating electrical devices in a server dissipates heat of the heat-generating electrical devices by using heat-absorbing liquid. The apparatus includes a container, an inlet pipe, and an outlet pipe. The container contains a non-conductive coolant liquid and the plurality of heat-generating electrical devices are entirely submerged in the coolant liquid.

US 2020/214169 A1 discloses an electronic device includes: a heat generating component; a board disposed in a vertical direction, the heat generating component mounted on a first surface of the board; a first thermally conductive member superposed on a second surface of the board opposite the first surface of the board; a plurality of second thermally conductive members extending in a horizontal direction from a first surface of the first thermally conductive member; a third thermally conductive member facing the first surface of the board, the third thermally conductive member secured to the distal end portions of the plurality of second thermally conductive members; a housing including a first wall portion superposed on a second surface of the first thermally conductive member, and a second wall portion opposite the first wall portion; and a heat sink provided on an outer surface of the second wall portion.

### SUMMARY

The embodiments of the present disclosure have been developed based on developers' appreciation of the shortcomings associated with the prior art.

In particular such shortcomings may comprise: (1) deformation of immersion cases due to insertion of immersion cooling liquid; (2) inconvenience while performing racking or de-racking operations of the immersions cases from a rack structure; and/or (3) inefficient space utilizations of space in the rack structure. The object of the invention is solved by a rack system according to claim 1. Preferred embodiments are presented in the dependent claims

### BRIEF DESCRIPTION OF THE FIGURES

Further features and advantages of the present disclosure will become apparent from the following detailed description, taken in combination with the appended drawings, in which:
FIG. 1 illustrates a perspective view of a rack system for housing rack mounted assembly;
FIG. 2 illustrates another perspective view of the rack system;
FIG. 3 illustrates a perspective view of the rack mounted assembly;
FIGs. 4-6 illustrate perspective views of different non-limiting examples of pre-deformed immersion cases;
FIGs. 7A and 7B illustrates a two-dimensional view of the immersion case 400 before and after insertion of the dielectric immersion cooling liquid;
FIGs. 8-10 illustrate perspective views of different non-limiting examples of immersion cases with reinforcement members; and
FIGs. 11-12 illustrate intensity of deformations of the immersion cases filled with the dielectric immersion cooling liquid.

It is to be understood that throughout the appended drawings and corresponding descriptions, like features are identified by like reference characters. Furthermore, it is also to be understood that the drawings and ensuing descriptions are intended for illustrative purposes only and that such disclosures do not provide a limitation on the scope of the claims. The various drawings are not to scale.

### DETAILED DESCRIPTION

The instant disclosure is directed to address at least some of the deficiencies of the current technology. In particular, the instant disclosure describes a rack system for housing an electronic device.

Unless otherwise defined or indicated by context, all technical and scientific terms used herein have the same meaning as commonly understood by one of ordinary skill in the art to which the described examples appertain to.

In the context of the present specification, unless provided expressly otherwise, the words "first", "second", "third", *etc.* have been used as adjectives only for the purpose of allowing for distinction between the nouns that they modify from one another, and not for the purpose of describing any particular relationship between those nouns. Thus, for example, it should be understood that, the use of the terms "first processor" and "third processor" is not intended to imply any particular order, type, chronology, hierarchy or ranking (for example) of/between the server, nor is their use (by itself) intended to imply that any "second server" must necessarily exist in any given situation. Further, as is discussed herein in other contexts, reference to a "first" element and a "second" element does not preclude the two elements from being the same actual real-world element. Thus, for example, in some instances, a "first" server and a "second" server may be the same software and/or hardware, in other cases they may be different software and/or hardware.

It will be understood that when an element is referred to as being "connected" or "coupled" to another element, it can be directly or indirectly connected or coupled to the other element or intervening elements that may be present. In contrast, when an element is referred to as being "directly connected" or "directly coupled" to another element, there are no intervening elements present. Other words used to describe the relationship between elements should be interpreted in a like fashion (*e.g.,* "between" versus "directly between," "adjacent" versus "directly adjacent," *etc.*)*.*

In the context of the present specification, when an element is referred to as being "associated with" another element, in certain examples, the two elements can be directly or indirectly linked, related, connected, coupled, the second element employs the first element, or the like without limiting the scope of present disclosure.

The terminology used herein is only intended to describe particular representative examples and is not intended to be limiting of the present technology. As used herein, the singular forms "a," "an" and "the" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof.

Furthermore, as an aid to understanding, the following description may describe relatively simplified implementations of the present technology. As persons skilled in the art would understand, various implementations of the present technology may be of a greater complexity.

In the context of the present specification, when an element is referred to as an electronic device, the element may include but is not limited to: servers including blade servers; disk arrays/storage systems; storage area networks; network attached storage; storage communication systems; work stations; routers; telecommunication infrastructure/switches; wired, optical and wireless communication devices; cell processor devices; printers; power supplies; displays; optical devices; instrumentation systems including hand-held systems; military electronics; etc. Many of the concepts will be described and illustrated herein as applied to an array of computer servers. However, it is to be realized that the concepts described herein could be used on other electronic devices as well.

With these fundamentals in place, the instant disclosure is directed to address at least some of the deficiencies of the current technology. In particular, the instant disclosure describes a rack system for housing an electronic device.

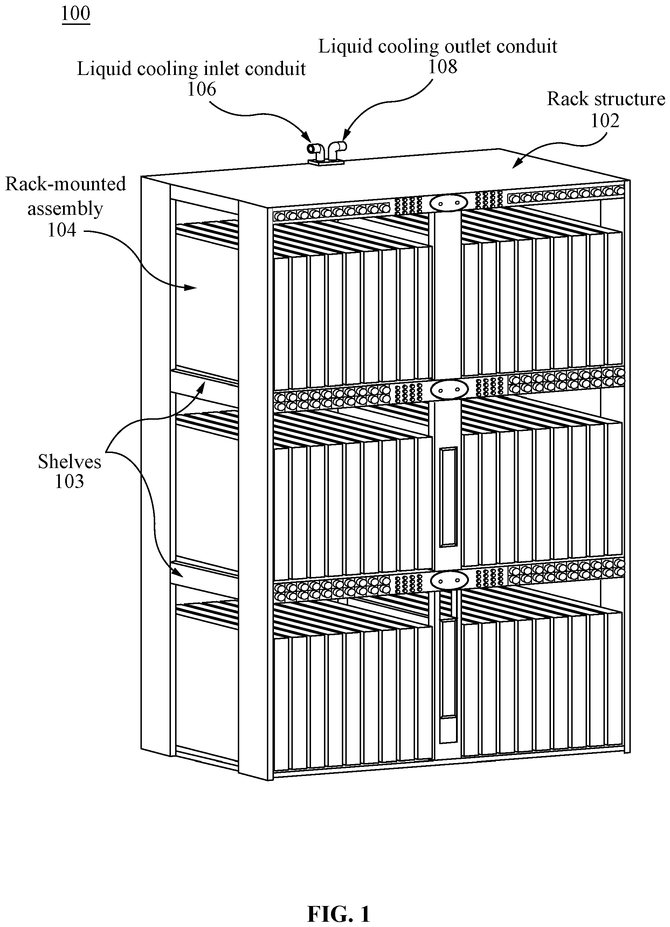

FIG. 1 illustrates a perspective view of a rack system **100** for housing a rack mounted assembly 104. As shown, the rack system **100** may include a rack structure **102**, a rack mounted assembly **104**, a liquid cooling inlet conduit **106** and a liquid cooling outlet conduit **108.**

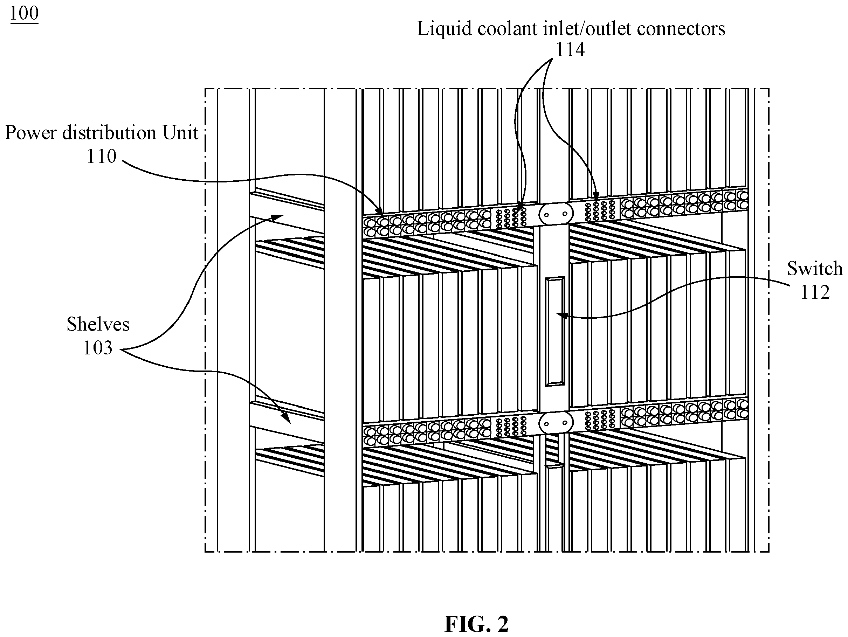

FIG. 2 illustrates another perspective view of the rack system **100**, in accordance with various non-limiting embodiments of the present disclosure. As shown, the rack system **100** may further comprise a power distribution unit **110**, a switch **112**, and liquid coolant inlet/outlet connectors **114.** It is to be noted that the rack system **100** may include other components such as heat exchangers, cables, pumps or the like, however, such components have been omitted from FIGs. 1 and 2 for the purpose of simplicity. As shown in FIGs. 1 and 2, the rack structure **102** may include shelves **103** to accommodate one or more rack-mounted assemblies **104.** In certain non-limiting examples, the one or more rack mounted assemblies **104** may be racked vertically on the shelves **103.**

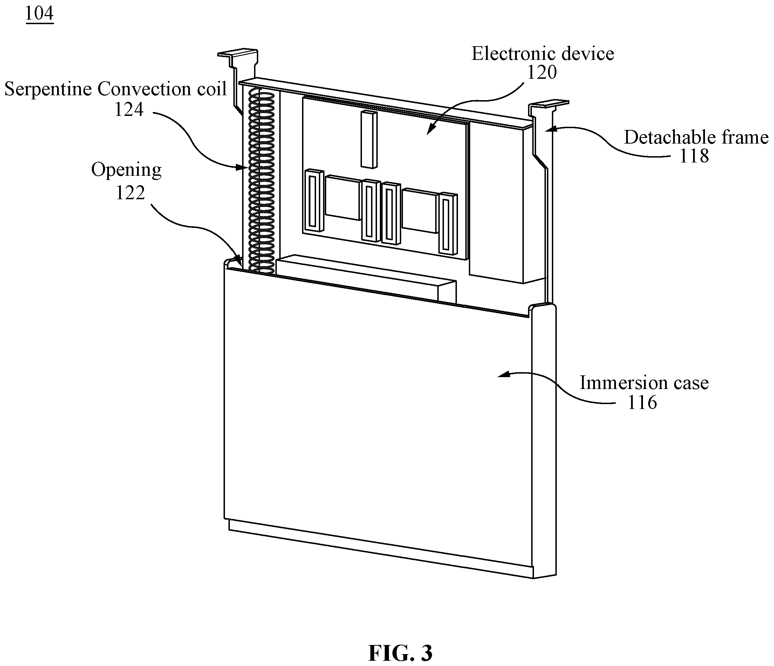

FIG. 3 illustrates a perspective view of the rack mounted assembly 104. As shown, the rack mounted assembly **104** may include an immersion case **116** and a detachable frame **118.** The detachable frame **118** may hold an electronic device **120** and may be immersed in the immersion case **116.**

It is contemplated that the electronic device **120** may generate a significant amount of heat. To this end, the rack system **100** may use a mechanism to cool down the electronic device **120** to prevent the electronic device **120** from getting damaged. To do so, in certain non-limiting examples, an immersion cooling liquid may be inserted in the immersion case **116.** Further, the detachable frame **118** including the electronic device **120** may be immersed in the immersion case **116.** In certain non-limiting examples, the immersion cooling liquid and the detachable frame **118** may be inserted to the immersion case **116** *via* an opening **122** at the top of the immersion case **116.** In certain non-limiting examples, the detachable frame **118** may be attached in a sealed configuration to the immersion case **116.** While in other embodiments, the detachable frame **118** may be attached in a non-sealed configuration to the immersion case **116.**

In certain non-limiting examples, the immersion cooling liquid may be dielectric immersion cooling liquid. All the electronic and thermally active components associated with the electronic device **120** may be immersed in the dielectric immersion cooling liquid. The dielectric cooling liquid may be in a direct contact with the electronic and thermally active components associated with the electronic device **120.** Thus, the immersion case **116** may act as a container containing the electronic device **120** and the dielectric immersion cooling liquid. The dielectric immersion cooling liquid may cool the electronic device **120.**

The dielectric immersion cooling liquid that may be used in various examples may include but are not limited to Fluorinert^{™} FC-3283, Fluorinert^{™} FC-43, Silicone oil 20, Silicone oil 50, Sobyean oil, S5 X (Shell), SmartCoolant (Submer), ThermaSafe R^{™} (Engineering fluids), Novec^{™} 7100 or the like. It is to be noted that any suitable dielectric immersion cooling may be employed in various non-limiting examples, provided the dielectric immersion cooling liquid is capable of providing an insulation among various electronic and thermally active components associated with the electronic device **120** along with a capability of cooling the components.

In certain non-limiting examples, the immersion case **116** may also include a convection inducing structure to cool/induce convection in the dielectric immersion liquid. By way of a non-limiting example, the convection inducing structure may be a serpentine convection coil **124** attached to the detachable frame **118.** The serpentine convection coil **124** may be fluidly coupled to the liquid cooling inlet conduit **106** and the liquid cooling outlet conduit **108** *via* the liquid coolant inlet/outlet connectors **114.** The serpentine convection coil **124** may allow a flow of a circulating cooling liquid. The circulating cooling liquid, by means of convection, may cool down the dielectric immersion cooling system. Thereby, making the cooling mechanism of the electronic device **120** a hybrid cooling mechanism.

Further, the electronic device **120** may be connected to the power distribution unit **110** and the switch **112** *via* power and network cables (not illustrated) to facilitate powering the electronic device **120** and to facilitate communication between the electronic device **120** and external devices (not illustrated) through the switch **112.**

As previously noted, that the dielectric immersion cooling liquid may be inserted in the immersion case **116** for cooling the electronic device **120.** The dielectric immersion cooling liquid may exert some pressure P on the walls of the immersion case **116.** This may result in outward deformation (i.e. inflation and/or bulging) of the immersion case **116.** The outward deformation may affect the racking and de-racking operations of the immersion case **116** over the shelves **103.** As such, the immersion cases **116** may be difficult to remove from the rack structure **102.** The deformation may also affect the proper space utilization of the rack structure **102.** By way of example, if one shelf **103** is designed to accommodate 16 empty immersion cases **116,** however due to deformation of the immersion cases **116,** the shelf **103** might now accommodate a fewer number of filled immersion cases **116.**

With this said, in various non-limiting examples of the present disclosure, the immersion case **116** may define means for controlling deformation of the immersion case **116**, such that when an immersion cooling liquid is inserted in the immersion case **116**, the means for controlling deformation may limit the deformation of the immersion case **116** such that the immersion case **116** may remain rackable and de-rackable from the rack structure **102** (as shown in FIG. 1) receiving the immersion case **116.**

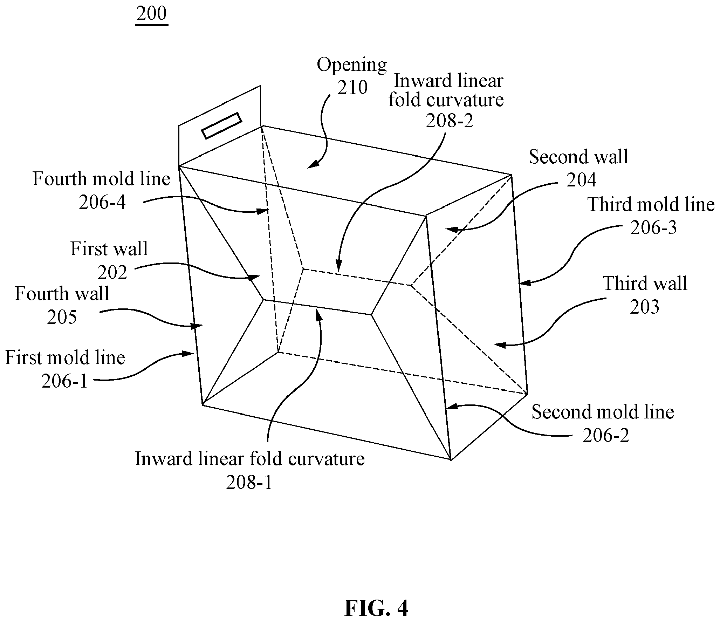

In certain non-limiting examples, the immersion case **116** may be pre-deformed to counter the effect of the deformation caused by the insertion of the dielectric immersion cooling liquid. FIGs. 4-6 illustrate perspective views of different non-limiting examples of pre-deformed immersion cases (**200, 300,** and **400** respectively), in accordance with various non-limiting examples of the present disclosure. In the views of FIGs. 4-6, pre-deformations of the immersion cases (**200, 300,** and **400** respectively) are exaggerated for illustration purposes.

Each of the immersion cases (**200**, **300**, and **400**) may include a first wall (**202, 302**, and **402** respectively) and a second wall (**204**, **304**, and **404** respectively) opposite to the first wall (**202**, **302**, and **402**, respectively), third side wall (**203, 303**, and **403**), fourth wall (**205, 305**, and **405**) and an opening (**210, 310**, and **410**). The dielectric immersion cooling liquid and the electronic device **120** may be inserted to the immersion cases (**200**, **300**, and **400**) *via* the opening (**210**, **310**, and **410**). In certain non-liming examples, the immersion cases (**200**, **300,** and **400**) may be constructed from any suitable metal, such as for example aluminum, steel, galvanized steel, stainless steel, copper or the like.

It is to be noted that the structural details discussed below for the first wall (**202**, **302**, and **402**) and the second wall (**204**, **304**, and **404**) may be equally applicable to the third side wall (**203**, **303**, and **403**) and fourth wall (**205, 305**, and **405**).

The dielectric immersion cooling liquid inserted in the immersion cases (**200**, **300**, and **400**) may apply a pressure P on the first wall (**202, 302**, and **402**) and the second wall (**204**, **304,** and **404**). In certain non-limiting examples, the first wall (**202, 302**, and **402**) and the second wall (**204**, **304**, and **404**) may be designed in a manner that the first wall (**202, 302**, and **402**) and the second wall (**204**, **304,** and **404**) define a first surface position P1 when not subjected to the pressure P thereacross and a second surface position P2 when subject to the pressure P thereacross. It is to be noted that the pressure P may be a result of inserting the immersion cooling liquid in the immersion cases (**200**, **300**, and **400**).

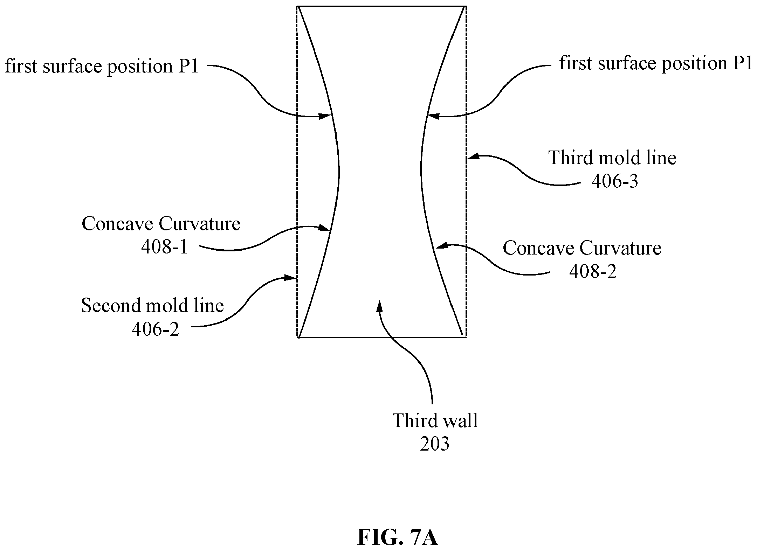

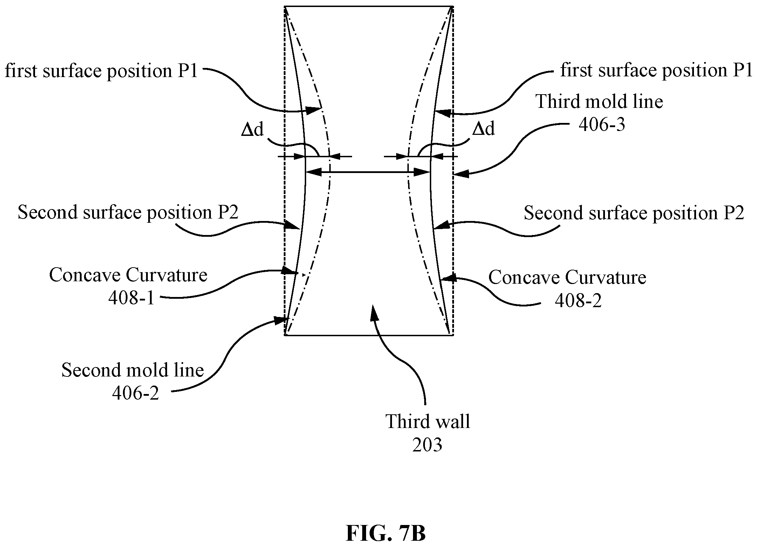

FIGs. 7A and 7B illustrates two-dimensional views of the immersion case **400** before and after insertion of the dielectric immersion cooling liquid, in accordance with various examples of the present disclosure. FIG. 7A illustrates the first surface position P1 of the first wall **402** and the second wall **404** without any dielectric immersion looking liquid in the immersion case **400.** FIG. 7B illustrates the second surface position P2 of the first wall **402** and the second wall **404** when the dielectric immersion cooling liquid may be inserted into the immersion case **400.** The dielectric immersion cooling liquid may apply the pressure P over first wall **402** and the second wall **404.** To this end, the first wall **402** and/or the second wall **404** may tend to move towards the second mold line **406-2** and the third mold line **406-3** respectively by the predetermined distance Δd.

It is to be noted that although FIGs. 7A and 7B illustrate two-dimensional cross-sectional views of the immersion case **400**, however, similar concept may be equally applicable to the immersion cases **200** and **300 as** well without limiting the scope of present disclosure.

Returning to FIG. 4-6, in certain non-limiting examples, the first surface position P1 may represent initial positions of the first wall **(202, 302,** and **402)** and/or the second wall **(204, 304,** and **404**) before the insertion of the dielectric immersion cooling liquid in the immersion cases **(200, 300**, and **400**). Also, the second surface position P2 may represent final positions of the first wall (**202**, **302**, and **402**) and the second wall (**204**, **304,** and **404)** after the insertion of the dielectric immersion cooling liquid in the immersion cases **(200, 300,** and **400).**

In certain non-limiting examples, the first surface position P1 and the second surface position P2 may be defined with reference to the outside mold lines such as a first mold line **(206-1, 306-1,** and **406-1),** a second mold line **(206-2, 306-2,** and **406-2),** a third mold line **(206-3, 306-3,** and **406-3),** and a fourth mold line **(206-4, 306-4,** and **406-4)** associated with the immersion cases **(200, 300,** and **400).**

In certain non-limiting examples, the first surface position P1 may be located on the inside of the outside mold lines and the second surface position P2 may be located on the inside of on the outside mold lines, or be aligned with the outside mold lines, depending on the pressure P applied by the dielectric immersion cooling liquid. In other words, the outside mold lines may define an extent to which the first wall **(202, 302,** and **402)** and the second wall **(204, 304,** and **404)** may be deformed. A slight bulging of the second surface position P2 beyond the outside mold lines may be acceptable provided that this does not impede with racking and de-racking of the immersion cases **(200, 300,** and **400).**

In certain non-limiting examples, in response to the pressure P, the second surface position P2 may include moving the at least one of the first wall **(202, 302,** and **402)** and the second wall **(204, 304,** and **404)** by a predetermined distance Δd from the first surface position P1 toward the outside mold lines. The at least one of the first wall **(202, 302,** and **402)** and the second wall **(204, 304,** and **404)** is therefore substantially straightened when in the second surface position P2 in comparison to when in the first surface position P1. It may be noted that the at least one of the first wall **(202, 302**, and **402)** and the second wall **(204, 304,** and **404)** may not be entirely straight when in the second surface position P2; it may be still be slightly deflected inwardly; it may even be slighted deflected outwardly as long as it does not impede racking or de-racking operations. The person of ordinary skill in the art will be able to determine the proper shape and construction of the immersion case **(200**, **300**, and **400**) in view of its size, the material used in its construction, a thickness of the material, and the expected weight of the immersion cooling liquid. The predetermined distance Δd may be within a distance from the outside mold lines to the first surface position P1. In certain non-limiting examples, the first surface position P1 may lie between 2 to 5mm from the outside mold lines.

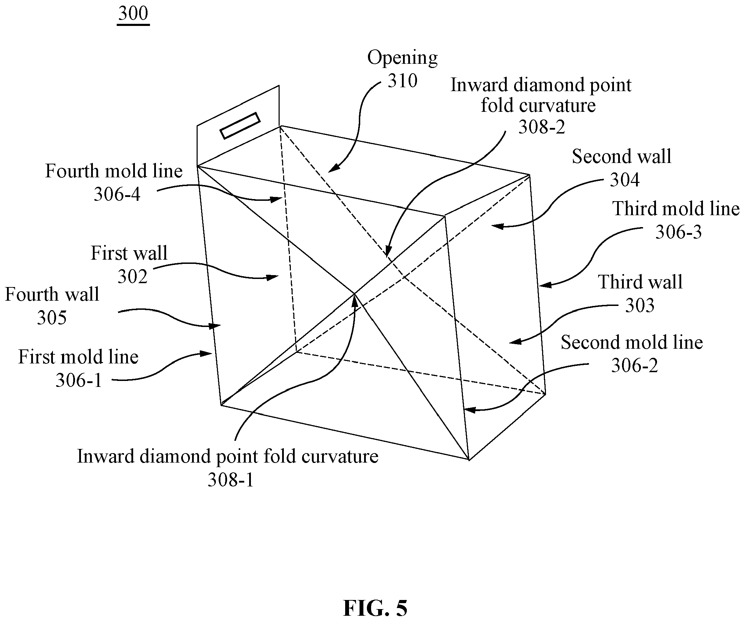

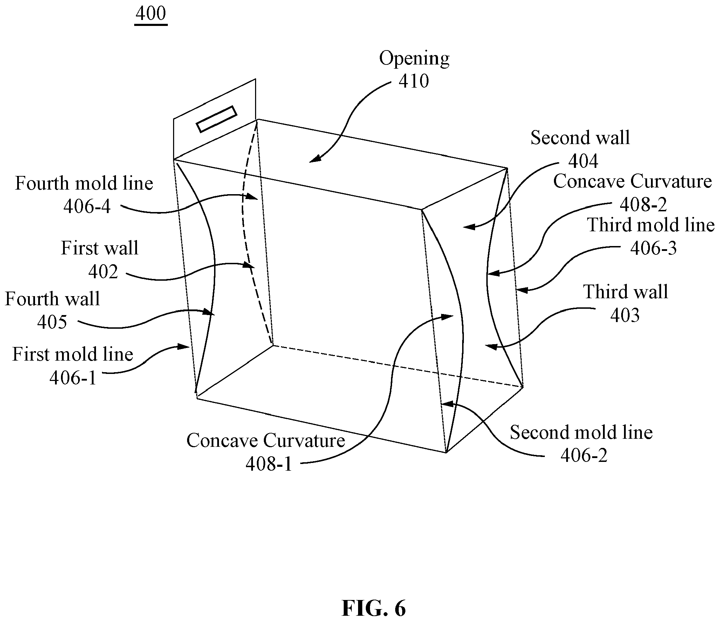

In certain non-limiting examples, the first surface position P1 may define an inward curvature of the first wall **(202, 302**, and **402)** and/or of the second wall **(204**, **304,** and **404**) with respect to the outside mold lines. It is to be noted that, in different non-limiting examples, different inward curvatures may be adapted by the first wall **(202, 302,** and **402)** and/or the second wall **(204**, **304,** and **404).** By way of examples, without limiting the scope of present disclosure, FIG. 4 illustrates the immersion case **200,** where the first surface position P1 may define inward linear fold curvatures (**208-1** and **208-2**), FIG. 5 illustrates the immersion case 300, where the first surface position P1 may define inward diamond point fold curvatures (**308-1** and **308-2**)**,** and FIG. 6 illustrates the immersion case **400,** where the first surface position P1 may define concave curvatures (**408-1** and **408-2).** It is to be noted that any suitable inward curvature may be employed in various non-limiting examples of the present disclosure, as long as the the second surface position P2 upon application of the pressure P remains substantially within the outside mold lines.

Thus, by virtue of the first surface position P1 and the inward curvatures, the immersion cases (**200**, **300**, and **400)** may limit the deformation due to pressure P as applied by the dielectric immersion cooling liquid. As a result, the immersion cases **(200, 300,** and **400)** may remain rackable in the frame structure **102** in an efficient manner. Also, the de-racking operation of the immersion cases (**200**, **300**, and **400)** may be performed without any inconvenience.

It is to be noted that the immersion cases **(200, 300,** and **400)** may have sufficient internal space to allow the insertion of the electronic device **120,** even in the absence of the dielectric immersion cooling liquid.

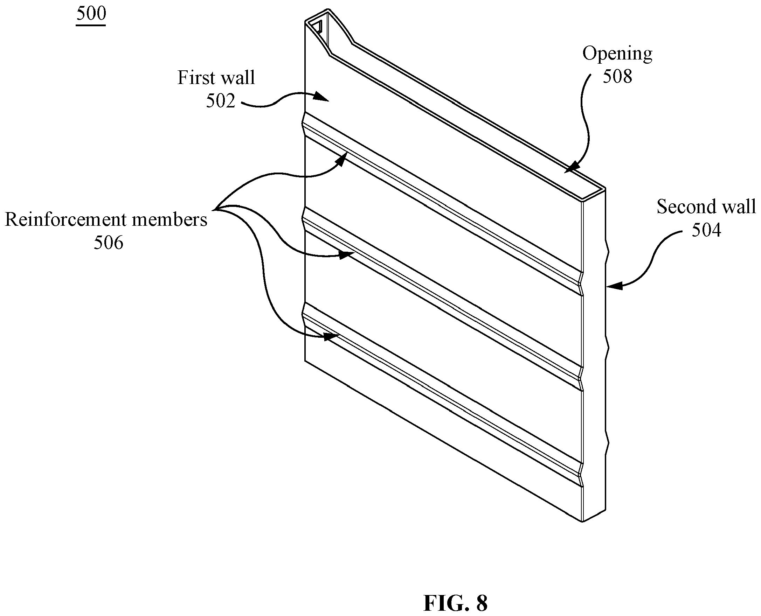

FIGs. 8-10 illustrate perspective views of different non-limiting examples of immersion cases **(500, 600,** and **700** respectively) with reinforcement members, in accordance with various non-limiting examples of the present disclosure.

Each of the immersion cases **(500, 600,** and **700)** may include a first wall **(502, 602,** and **702** respectively) and a second wall **(504, 604,** and **704** respectively) opposite to the first wall **(502, 602,** and **702,** respectively) and an opening **(508, 608,** and **708).** The dielectric immersion cooling liquid and the electronic device **120** may be inserted to the immersion cases **(500, 600,** and **700)** *via* the opening **(508, 608,** and **708).** In certain non-liming examples, the immersion cases **(500, 600,** and **700)** may be constructed from any suitable metal, such as for example aluminum, steel, galvanized steel, stainless steel, copper or the like.

It is to be noted that the immersion cases **(500, 600,** and **700)** may include other walls (as illustrated in the FIGs. 8-10) and the structural details discussed below for the first wall **(502, 602,** and **702)** and the second wall **(504, 604,** and **704)** may be equally applicable to the other walls of the immersion cases **(500, 600,** and **700)** as well.

In certain non-limiting examples, in addition to or alternative to the inward curvatures as discussed previously, the first wall **(502, 602,** and **702)** and the second wall **(504, 604,** and **704)** may define reinforcement members **(506, 606,** and **706** respectively) coupled to the first wall **(502, 602,** and **702)** and the second wall **(504, 604,** and **704).** The reinforcement members **(506, 606,** and **706)** may be coupled in a manner such that when the dielectric immersion cooling liquid is inserted in the immersion cases **(500, 600,** and **700),** the reinforcement members **(506, 606,** and **706)** reduce deformation of the immersion cases **(500, 600,** and **700)** by deflecting the first wall **(502, 602,** and **702)** and the second wall **(504, 604,** and **704)** towards the inner side of the immersion cases **(500, 600,** and **700).**

It is to be noted that although in the FIGs. 8-10 the reinforcement members **(506, 606,** and **706)** have been illustrated as coupled externally to the first wall **(502, 602,** and **702)** and the second wall **(504, 604**, and **704)** in some of the non-limiting examples, the reinforcement members **(506, 606,** and **706)** may be coupled internally to the first wall **(502, 602,** and **702)** and the second wall **(504, 604,** and **704).** In some other non-limiting examples, the reinforcement members **(506, 606,** and **706)** may be imbedded in the first wall **(502, 602,** and **702)** and the second wall **(504, 604,** and **704).** Such examples have not been illustrated for the purpose of simplicity.

In certain non-limiting examples, the reinforcement members **(506, 606,** and **706)** may be arranged in one dimension as illustrated on the FIGs. 8-10. It is to be noted that, although the reinforcement members **(506, 606,** and **706)** have been illustrated as horizontally arranged, however, in other non-limiting examples, the reinforcement members **(506, 606,** and **706)** may be arranged vertically.

In certain non-limiting examples, the reinforcement members **(506, 606,** and **706)** which are coupled to the first wall **(502, 602,** and **702)** may be arranged in parallel to each other and the reinforcement members (not illustrated) which are coupled to the second wall **(504, 604,** and **704)** may be arranged in parallel to each other.

In certain non-limiting examples, the reinforcement members **(506, 606,** and **706)** may be arranged in two dimensions. In other words, the reinforcement members **(506, 606,** and **706)** may be arranged vertically as well as horizontally. By way of an example, the reinforcement members **(506, 606,** and **706)** may be arranged in a grid type arrangement. In yet another non-limiting example, the reinforcement members **(506, 606,** and **706)** may be arranged in angular orientations. It is to be noted that how the reinforcement members **(506, 606,** and **706)** have been arranged should not limit the scope of present disclosure.

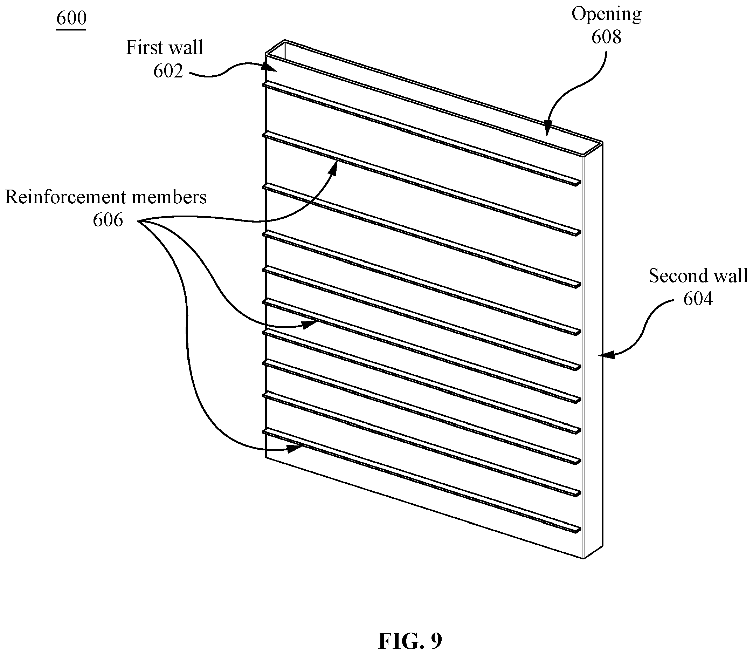

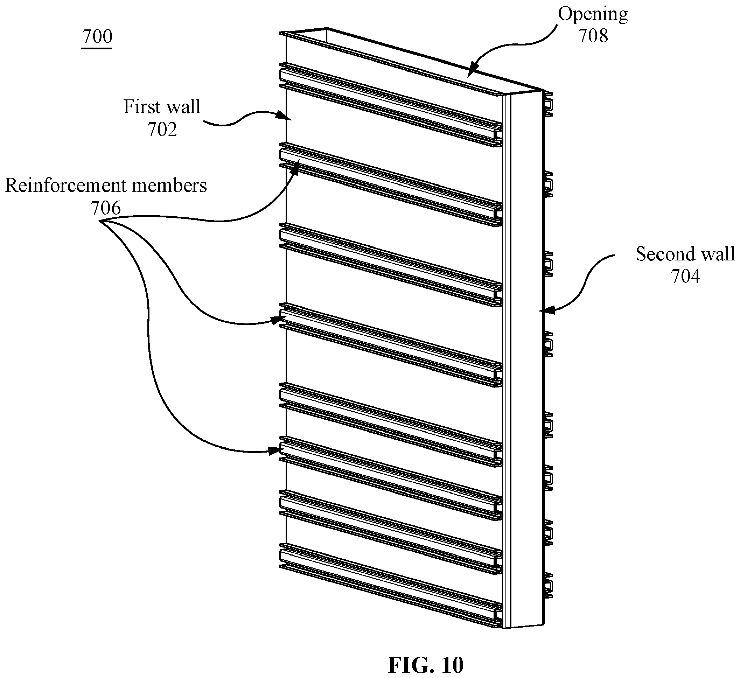

In certain non-limiting examples, each of the reinforcement members **(506, 606,** and 706) include at least one metallic strip. By way of an example, the metallic strip may be constructed from aluminum, steel, galvanized steel, stainless steel, copper or the like. As shown FIG. 9, each of the reinforcement member **606** may include one metallic strip and multiple reinforcement members **606** may be coupled to the first wall **602.** FIG. 10 illustrates another example where each of the reinforcement member **706** may include a set of three metallic strips and multiple reinforcement members **706** may be coupled to the first wall **702.**

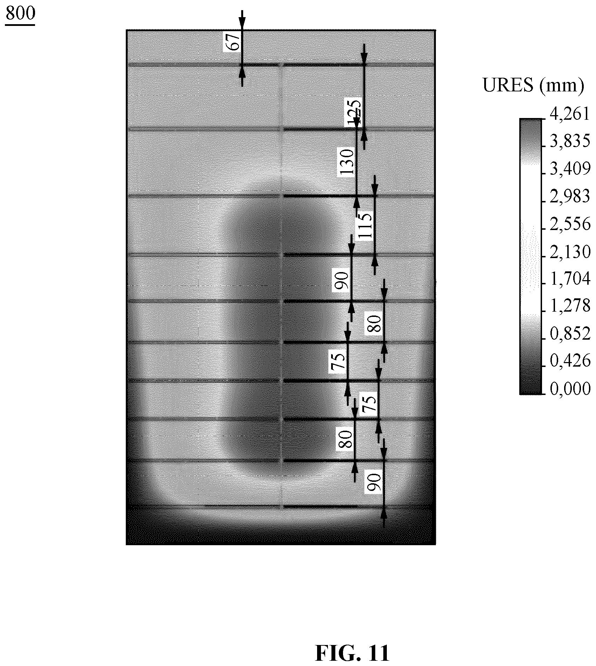

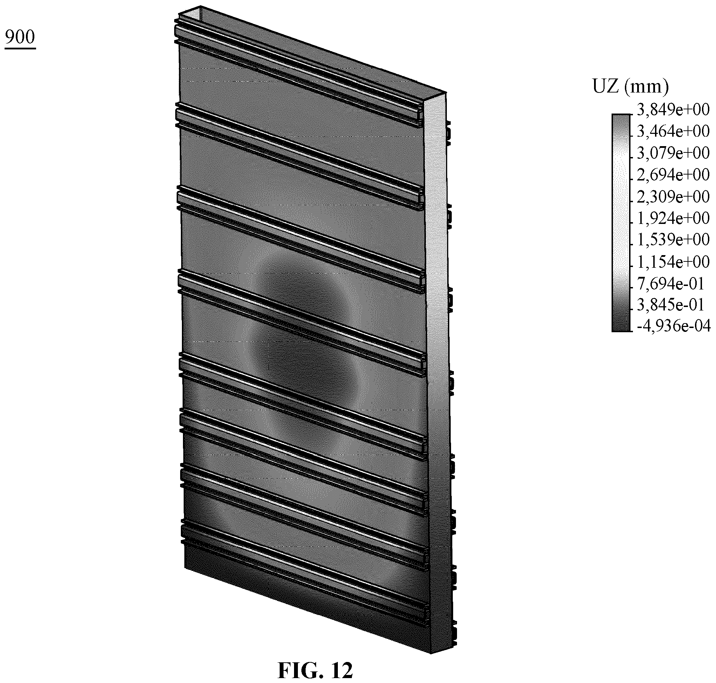

FIGs. 11-12 illustrate intensity of deformations of the immersion cases **600** and **700** respectively. In particular, FIG. 11 illustrates deformed immersion case **800** corresponding to the immersion case **600** filled with the dielectric immersion cooling liquid. Also, FIG. 12 illustrates deformed immersion case **900** corresponding to the immersion case **700** filled with the dielectric immersion cooling liquid.

Thus, by virtue of the reinforcement members **(506, 606,** and **706),** the immersion cases **(500, 600,** and **700)** may limit the deformation due to pressure P as applied by the dielectric immersion cooling liquid. As a result, the immersion cases **(500, 600,** and **700)** may remain rackable in the frame structure **102** in an efficient manner. Also, the de-racking operation of the immersion cases **(200, 300,** and **400)** may be performed without any inconvenience.

## Claims

1. A rack system **(100)** for housing an electronic device **(120)** comprising:
an immersion case **(200, 300,** and **400)** configured to provide housing to the electronic device **(120),** wherein,
the immersion case **(200, 300,** and **400)** includes a first wall **(202, 302,** and **402),** and a second wall **(204, 304,** and **404)** opposite to the first wall **(202, 302,** and **402);**
**characterized in that**:
the first wall **(202, 302,** and **402)** and the second wall **(204, 304,** and **404)** define an inward curvature for controlling deformation of the immersion case **(200, 300,** and **400),** such that when an immersion cooling liquid is inserted in the immersion case **(200, 300,** and **400),** the inward curvature for controlling deformation limiting the deformation of the immersion case **(200, 300,** and **400)** such that the immersion case **(200, 300,** and **400)** remains rackable and de-rackable from a rack structure **(102)** receiving the immersion case **(200, 300,** and **400),**
wherein:
at least one of the first wall **(202, 302,** and **402)** and the second wall **(204, 304,** and **404)** define a first surface position **(P1)** when not subjected to a pressure **(P)** thereacross and a second surface position **(P2)** when subject to the pressure **(P)** thereacross, the pressure **(P)** resulting from inserting the immersion cooling liquid in the immersion case **(200, 300,** and **400),** and
the first surface position **(P1)** defines the inward curvature with respect to the outside mold lines **(206-1, 206-2, 206-3, 206-4, 306-1, 306-2, 306-3, 306-4, 406-1, 406-2, 406-3,** and **406-4).**

2. The rack system **(100)** of claim 1, wherein the first surface position **(P1)** and the second surface position **(P2)** are defined with reference to outside mold lines **(206-1, 206-2, 206-3, 206-4, 306-1, 306-2, 306-3, 306-4, 406-1, 406-2, 406-3,** and **406-4)** of the first wall **(202, 302,** and **402),** and the second wall **(204, 304,** and **404).**

3. The rack system **(100)** of any one of claim 1 or 2, wherein an extreme point on the first surface position (**P1**) lies inward between 2 to 5mm from the outside mold lines **(206-1, 206-2, 206-3, 206-4, 306-1, 306-2, 306-3, 306-4, 406-1, 406-2, 406-3,** and **406-4).**

4. The rack system **(100)** of claim 1, wherein the inward curvature is selected from an inward linear fold curvature **(208-1** and **208-2),** an inward diamond point fold curvature **(308-1** and **308-2),** a concave curvature **(408-1** and **408-2)** or a combination thereof.

5. The rack system **(100)** of any one of claims 1 to 4, wherein, in response to the pressure **(P),** the second surface position **(P2)** of the at least one of the first wall **(202, 302,** and **402)** and the second wall **(204, 304,** and **404)** is moved by a predetermined distance Δd from the first surface position (**P1**).

6. The rack system **(100)** of any of claims 1 to 5, wherein the immersion case **(200, 300, 400, 500, 600,** and **700)** further comprises a detachable frame **(118)** configured to hold the electronic device **(120).**

7. The rack system **(100)** of any of claims 1 to 6, wherein the immersion case **(200, 300, 400, 500, 600,** and **700)** further comprises an opening **(210, 310, 410, 508, 608,** and **708)** to insert the electronic device **(120)** and the immersion cooling liquid.

## Patentansprüche

1. Racksystem **(100)** zur Aufnahme einer elektronischen Vorrichtung **(120),** umfassend:
ein Tauchgehäuse **(200, 300** und **400),** das dazu konfiguriert ist, eine Aufnahme für die elektronische Vorrichtung **(120)** bereitzustellen, wobei
das Tauchgehäuse **(200, 300** und **400)** eine erste Wand **(202, 302** und **402)** und eine zweite Wand **(204, 304** und **404)** gegenüber der ersten Wand **(202, 302** und **402)** beinhaltet;
**dadurch gekennzeichnet, dass**:
die erste Wand **(202, 302** und **402)** und die zweite Wand **(204, 304** und **404)** eine nach innen gerichtete Wölbung zur Deformationskontrolle des Tauchgehäuses **(200, 300** und **400)** derart definieren, dass, wenn eine Tauch-Kühlflüssigkeit in das Tauchgehäuse **(200, 300** und **400)** hineingegeben wird, die nach innen gerichtete Wölbung zur Deformationskontrolle die Deformation des Tauchgehäuses **(200, 300** und **400)** derart beschränkt, dass das Tauchgehäuse **(200, 300** und **400)** für den Einbau in und Ausbau aus einer Rackstruktur **(102)** geeignet bleibt, die das Tauchgehäuse **(200, 300** und **400)** aufnimmt,
wobei:
mindestens eine der ersten Wand **(202, 302** und **402)** und der zweiten Wand **(204, 304** und **404)** eine erste Oberflächenposition **(P1)** definiert, wenn sie quer darüber nicht mit einem Druck **(P)** beaufschlagt ist, und eine zweite Oberflächenposition **(P2)** definiert, wenn sie quer darüber mit dem Druck **(P)** beaufschlagt ist, wobei der Druck **(P)** durch das Hineingeben der Tauch-Kühlflüssigkeit in das Tauchgehäuse **(200, 300** und **400)** entsteht, und
die erste Oberflächenposition **(P1)** die nach innen gerichtete Wölbung in Bezug auf die äußeren Formenlinien **(206-1, 206-2, 206-3, 206-4, 306-1, 306-2, 306-3, 306-4, 406-1, 406-2, 406-3** und **406-4)** definiert.

2. Racksystem **(100)** nach Anspruch 1, wobei die erste Oberflächenposition **(P1)** und die zweite Oberflächenposition **(P2)** in Bezug auf äußere Formenlinien **(206-1, 206-2, 206-3, 206-4, 306-1, 306-2, 306-3, 306-4, 406-1, 406-2, 406-3** und **406-4)** der ersten Wand **(202, 302** und **402)** und der zweiten Wand **(204, 304** und **404)** definiert sind.

3. Racksystem **(100)** nach einem der Ansprüche 1 oder 2, wobei ein Extrempunkt auf der ersten Oberflächenposition **(P1)** nach innen zwischen 2 bis 5 mm von den äußeren Formenlinien **(206-1, 206-2, 206-3, 206-4, 306-1, 306-2, 306-3, 306-4, 406-1, 406-2, 406-3** und **406-4)** entfernt liegt.

4. Racksystem **(100)** nach Anspruch 1, wobei die nach innen gerichtete Wölbung aus einer nach innen gerichteten linearen Falzwölbung **(208-1** und **208-2),** einer nach innen gerichteten diamantspitzenförmigen Falzwölbung **(308-1** und **308-2),** einer konkaven Wölbung **(408-1** und **408-2)** oder einer Kombination daraus ausgewählt ist.

5. Racksystem **(100)** nach einem der Ansprüche 1 bis 4, wobei, als Reaktion auf den Druck **(P),** die zweite Oberflächenposition **(P2)** der mindestens einen der ersten Wand **(202, 302** und **402)** und der zweiten Wand **(204, 304** und **404)** um einen vorbestimmten Abstand Δd von der ersten Oberflächenposition **(P1)** wegbewegt wird.

6. Racksystem **(100)** nach einem der Ansprüche 1 bis 5, wobei das Tauchgehäuse **(200, 300, 400, 500, 600** und **700)** ferner einen abnehmbaren Rahmen **(118)** umfasst, der dazu konfiguriert ist, die elektronische Vorrichtung **(120)** zu halten.

7. Racksystem **(100)** nach einem der Ansprüche 1 bis 6, wobei das Tauchgehäuse **(200, 300, 400, 500, 600** und **700)** ferner eine Öffnung **(210, 310, 410, 508, 608** und **708)** umfasst, um die elektronische Vorrichtung **(120)** und die Tauch-Kühlflüssigkeit hineinzugeben.

## Revendications

1. Système de bâti **(100)** pour accueillir un dispositif électronique **(120)** comprenant :
un boîtier d'immersion **(200, 300, 400)** conçu pour fournir accueillir le dispositif électronique **(120),** dans lequel,
le boîtier d'immersion **(200, 300,** et **400)** comporte une première paroi **(202, 302,** et **402),** et une seconde paroi **(204, 304,** et **404)** opposée à la première paroi **(202, 302,** et **402)** ; **caractérisé en ce que** :
la première paroi **(202, 302** et **402)** et la seconde paroi **(204, 304** et **404)** définissent une courbure vers l'intérieur pour commander la déformation du boîtier d'immersion **(200, 300** et **400),** de sorte que lorsqu'un liquide de refroidissement par immersion est inséré dans le boîtier d'immersion **(200, 300** et **400),** la courbure vers l'intérieur pour commander la déformation limitant la déformation du boîtier d'immersion **(200, 300** et **400)** de sorte que le boîtier d'immersion **(200, 300** et **400)** reste rackable et dérackable à partir d'une structure de bâti **(102)** recevant le boîtier d'immersion **(200, 300,** et **400),**
dans lequel :
au moins l'une de la première paroi **(202, 302,** et **402)** et de la seconde paroi **(204, 304,** et **404)** définissent une première position de surface **(P1)** lorsqu'elles ne sont pas soumises à une pression **(P)** à travers celles-ci et une seconde position de surface **(P2)** inférieure lorsqu'elles sont soumises à la pression **(P)** à travers celles-ci, la pression **(P)** inférieure résultant de l'insertion du liquide de refroidissement par immersion dans le boîtier d'immersion **(200, 300,** et **400),** et
la première position de surface **(P1)** définit la courbure vers l'intérieur par rapport aux lignes de moulage extérieures **(206-1, 206-2, 206-3, 206-4, 306-1, 306-2, 306-3, 306-4, 406-1, 406-2, 406-3** et **406-4).**

2. Système de bâti **(100)** selon la revendication 1, dans lequel la première position de surface **(P1)** et la seconde position de surface **(P2)** sont définies en référence à des lignes de moulage extérieures **(206-1, 206-2, 206-3, 206-4, 306-1, 306-2, 306-3, 306-4, 406-1, 406-2, 406-3** et **406-4)** de la première paroi **(202, 302,** et **402),** et de la seconde paroi **(204, 304,** et **404).**

3. Système de bâti **(100)** selon l'une quelconque des revendications 1 ou 2, dans lequel un point extrême sur la première position de surface **(P1)** est situé vers l'intérieur entre 2 et 5 mm à partir des lignes de moulage extérieures **(206-1, 206-2, 206-3, 206-4, 306-1, 306-2, 306-3, 306-4, 406-1, 406-2, 406-3** et **406-4).**

4. Système de bâti **(100)** selon la revendication 1, dans lequel la courbure vers l'intérieur est choisie parmi une courbure de pliage linéaire vers l'intérieur **(208-1** et **208-2),** une courbure de pliage en pointe de diamant vers l'intérieur **(308-1** et **308-2),** une courbure concave **(408-1** et **408-2)** ou une combinaison de celles-ci.

5. Système de bâti **(100)** selon l'une quelconque des revendications 1 à 4, dans lequel, en réponse à la pression **(P),** la seconde position de surface **(P2)** de l'au moins une de la première paroi **(202, 302** et **402)** et de la seconde paroi **(204, 304** et **404)** est déplacée d'une distance prédéterminée Δd de la première position de surface **(P1).**

6. Système de bâti **(100)** selon l'une quelconque des revendications 1 à 5, dans lequel le boîtier d'immersion **(200, 300, 400, 500, 600** et **700)** comprend en outre un cadre amovible (118) conçu pour maintenir le dispositif électronique **(120).**

7. Système de bâti **(100)** selon l'une quelconque des revendications 1 à 6, dans lequel le boîtier d'immersion **(200, 300, 400, 500, 600** et **700)** comprend en outre une ouverture **(210, 310, 410, 508, 608** et **708)** pour insérer le dispositif électronique **(120)** et le liquide de refroidissement par immersion.
